# EUROPEAN PATENT APPLICATION

(11) **EP 4 195 276 A1**
(43) Date of publication of application: **14.06.2023**
(21) Application number: 21213663.4
(22) Date of filing: 10.12.2021
(51) Int. Cl.: H01L 27/11, H01L 27/06

(54) **A STATIC RANDOM-ACCESS MEMORY DEVICE WITH A THREE-LAYERED CELL DESIGN**

(71) Applicant: Imec VZW, 3001 Leuven (BE)
(72) Inventor: HUYGHEBAERT, Cedric, 3001 Leuven (BE); SCHRAM, Tom, 3001 Leuven (BE); RADU, Iuliana, 3001 Leuven (BE)
(74) Representative: Roth, Sebastian

(57) **Abstract**

The present disclosure relates generally to static random-access memory (SRAM) devices. Specifically, the disclosure proposes a SRAM device with a three-layered SRAM cell design. The SRAM cell comprises a storage comprising four storage transistors, and comprises two access transistors to control access to the storage cell. The SRAM cell further comprises a stack of three layer structures. Two of the storage transistors are formed in a first layer structure of the stack, and two other of the storage transistors are formed in a second layer structure of the stack adjacent to the first layer structure. The two access transistors are formed in a third layer structure of the stack adjacent to the second layer structure. Each layer structure comprises a semiconductor material, the transistors in the layer structure are based on that semiconductor material, and at least two of the three layer structures comprise a different type of semiconductor material.

## Description

### TECHNICAL FIELD

The present disclosure relates generally to static random-access memory (SRAM) devices. Specifically, the disclosure proposes a SRAM device with a three-layered SRAM cell design. The SRAM cell comprises a stack of three layer structures, and storage transistors and access transistors that are distributed among the three layer structures.

### BACKGROUND OF THE INVENTION

A SRAM device is a type of random-access memory (RAM) device that uses latching circuitry (flip-flop) to store each bit in a SRAM cell (memory cell) of the SRAM device. SRAM devices are volatile memory devices, i.e., the stored data is lost when power is removed from the SRAM device.

The term "static" differentiates SRAM devices from dynamic random-access memory (DRAM) devices, which must be periodically refreshed. SRAM devices are faster and more expensive than DRAM devices. SRAM cells are typically used for a central processing unit (CPU) cache, as they are built of the same basic components as the logic circuitry, namely transistors, so they can be integrated together with the logic circuitry. DRAM devices are typically used for a computer's main memory.

Due to the number of transistors required to implement the SRAM cell (four storage transistors and two access transistors), the storage density of a SRAM device is lower than that of a DRAM device, and its price is higher than that of a DRAM device. In addition, the power consumption of a SRAM device is high when data is being actively read or written. However, SRAM devices are faster and easier to manage than DRAM devices.

SRAM devices maybe integrated as RAM or as cache memory in micro-controllers, or as the primary caches in powerful microprocessors, such as the x86 family, and many others, to store registers and parts of the state-machines used in some microprocessors.

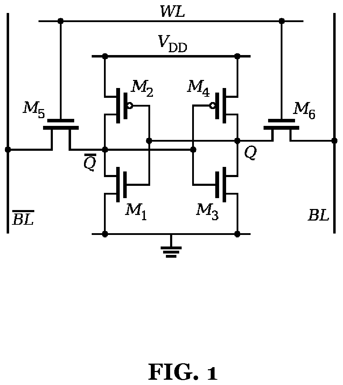

A typical SRAM cell design of a SRAM device is shown in FIG. 1. As mentioned above, the SRAM cell is made up of six transistors, for example, metal-oxide-semiconductor field-effect transistors (MOSFETs). Each bit is stored by the SRAM device in one SRAM cell, and there particularly in a storage cell including four storage transistors M1, M2, M3 and M4. These four storage transistors M1, M2, M3 and M4 form two cross-coupled inverters, as can be seen in FIG. 1. This transistor configuration has two stable states, which can be used to denote "o" and "1" of the stored bit. Two additional access transistors M5 and M6 serve to control the access to the storage cell during read and write operations..

Because there are six transistors in each SRAM cell of the SRAM device, a footprint of the SRAM cell is comparatively large.

### SUMMARY OF THE INVENTION

In view of the above, this disclosure has the objective to reduce the footprint of a SRAM cell. Reducing the footprint of the SRAM cell would allow decreasing the size of the SRAM device as a whole, and thus further densifying SRAM areas in microprocessor chips. Another objective of this disclosure is accordingly to provide a smaller SRAM device, and to reduce the size of chips for the same functionality. However, the reduction of the footprint of the SRAM cell should not have any impact on classical logic circuitry design.

These and other objectives are achieved by the solutions provided in the independent claims. Advantageous implementations are defined in the dependent claims.

The solutions of this disclosure are based on stacking the six transistors of the SRAM cell in a stack of three layer structures, and based on using different types of semiconductor materials for fabricating at least two of the three layer structures.

A first aspect of this disclosure provides a SRAM device comprising: a storage cell for storing a bit, the storage cell comprising four storage transistors; two access transistors configured to control access to the storage cell for storing or reading the bit; and a stack of layer structures comprising three layer structures; wherein two storage transistors of the four storage transistors are formed in a first layer structure of the stack; wherein two other storage transistors of the four storage transistors are formed in a second layer structure of the stack adjacent to the first layer structure; wherein the two access transistors are formed in a third layer structure of the stack adjacent to the second layer structure; wherein each layer structure of the three layer structures comprises a semiconductor material and the transistors in the layer structure are based on the semiconductor material; and wherein at least two of the three layer structures comprise a different type of semiconductor material.

By distributing the six transistors over the stack of the three layer structures, and by using different types of semiconductor materials in at least two of the three layer structures, the footprint of the SRAM cell can be significantly reduced. Further, reducing the footprint of the SRAM cell allows decreasing the size of the SRAM device as a whole. The reduction of the footprint of the SRAM cell as proposed by this disclosure has advantageously no impact on classical logic circuitry design.

Each layer structure of the stack may be based on a single semiconductor material, which is of a certain type of semiconductor material. In this case, one layer structure of the three layer structures is based on a different semiconductor material than at least one of the other layer structures of the three layer structures. Some or each of the layer structures may also be based on more than one semiconductor material, which maybe of the same type or maybe of different types of semiconductor material. In this case, one layer structure of the three layer structures is based on different types of semiconductor materials than at least one of the other layer structures. For instance, if each layer structure is based on two semiconductor materials, one layer structure may comprises two different types of semiconductor material than at least one of the other two layer structures.

In an implementation of the SRAM device, the type of semiconductor material comprises: a silicon-based semiconductor material, or a two-dimensional, 2D, semiconductor material, or a semiconductor oxide material.

This implementation distinguishes different types of semiconductor materials, as can be used in the three layer structures of the SRAM device of the first aspect. At least two of the three layer structures may comprise a different type of semiconductor material of these specific types. Notably, within one type of semiconductor material, there may be differences as well. For instance, a doping concentration or conductivity-type may be different, or certain material concentrations or ratios may be different. However, this is not enough for denoting a different type of semiconductor material in this disclosure. A different type of semiconductor in this disclosure means a different material system.

For example, silicon, silicon germanium, and silicon nitride would belong to the same type of semiconductor material in this disclosure. Likewise, for example, Molybdenum Di-Sulfide (MoS₂), Tungsten Di-Selenide (WSe₂) and Hafnium Di-Sulfide (HfS₂) would belong to the same type of 2D semiconductor materials. Likewise, for example, indium gallium zinc oxide (IGZO), indium tin oxide (ITO), and indium zinc oxide (IZO) would belong to the same type of semiconductor oxide materials.

In an implementation of the SRAM device, the first layer structure and the second layer structure each comprises a silicon-based semiconductor material; and the third layer structure comprises a 2D semiconductor material and/or a semiconductor oxide material.

That is, the first layer structure and the second structure comprise the same type of semiconductor material, while the third layer structure comprises a different type of semiconductor material. The first and the second layer structure do not comprise a 2D semiconductor material and/or a semiconductor oxide material, and the third layer structure does not comprise a silicon-based semiconductor material.

In an implementation of the SRAM device, with respect to a direction of stacking the layer structures of the stack: the second layer structure is formed above the first layer structure, and the third layer structure is formed above the first layer structure and the second layer structure.

For instance, the first layer structure may be formed on or above a substrate, and the second and the third layer structure may be formed on or above the first layer structure. Notably, in this disclosure "formed on" means formed directly on, and "formed above" means formed indirectly on with one or more other layers provided in between.

In an implementation of the SRAM device, the first layer structure and the second layer structure each comprises a 2D semiconductor material and/or a semiconductor oxide material; and the third layer structure comprises a silicon-based semiconductor material.

That is, again the first layer structure and the second layer structure comprise the same type of semiconductor material, while the third layer structure comprises a different type of semiconductor material. The first and the second layer structure does not comprise a silicon-based semiconductor material, and the third layer structure does not comprise 2D semiconductor material and/or semiconductor oxide material.

In an implementation of the SRAM device, with respect to a direction of stacking the layer structures of the stack: the second layer structure is formed above the third layer structure, and the first layer structure is formed above the third layer structure and the second layer structure.

For instance, the third layer structure may be formed on or above a substrate, and the second and the first layer structure may be formed on or above the third layer structure.

In an implementation of the SRAM device, the first layer structure is a doped layer structure of a first-conductivity type, and the second layer structure is a doped layer structure of a second conductivity-type.

Notably, the first and the second layer structure may thereby be of the same type of semiconductor material or may be of a different type of semiconductor material.

In an implementation of the SRAM device, the first storage transistor and the second storage transistor constitute a first complementary field effect transistor, CFET; and/or the third storage transistor and the fourth storage transistor constitute a second CFET.

This allows a further reduction of the size of the SRAM cell, and thus of the SRAM device as a whole.

In an implementation of the SRAM device, the first CFET and/or the second CFET is an integrated silicon-based nanosheet transistor.

In an implementation of the SRAM device, the SRAM device further comprises a first vertical element electrically connecting a gate of a first storage transistor of the two storage transistors in the first layer structure to a gate of a second storage transistor of the two other storage transistors in the second layer structure; and/or a second vertical element electrically connecting a gate of a third storage transistor of the two storage transistors in the first layer structure to a gate of a fourth storage transistor of the two other storage transistors in the second layer structure.

In an implementation of the SRAM device, the SRAM device further comprises: a third vertical element electrically connecting a source/drain of the first storage transistor, a source/drain of the second storage transistor, and a source/drain of a first access transistor of the two access transistors; and/or a fourth vertical element electrically connecting a source/drain of the third storage transistor, a source/drain of the fourth storage transistor, and a source/drain of a second access transistor of the two access transistors.

In an implementation of the SRAM device, the first vertical element is electrically connected to the fourth vertical element; and/or the second vertical element is electrically connected to the third vertical element.

The vertical elements of the above implementations enable connecting the different transistors of the SRAM cell, so that the SRAM cell can be formed in the three layer structures. The required wiring is substantially reduced by using the vertical elements, which thus contribute to the small footprint of the SRAM cell. At the same time, the reduced footprint has no impact on the circuit design of the SRAM cell.

In an implementation of the SRAM device, a source/drain of the first storage transistor and a source/drain of the third storage transistor are connected to a ground line; and a source/drain of the second storage transistor and a source/drain of the fourth storage transistors are connected to a supply voltage line.

In an implementation of the SRAM device, the SRAM device further comprises a wordline arranged above the stack and electrically connected to the gates of the two access transistors; or a wordline arranged between the second layer structure and the third layer structure and electrically connected to the gates of the two access transistors; and the SRAM device further comprises: a bitline arranged in the third layer structure and connected to the source/drain of the first access transistor, and a complementary bitline arranged in the third layer structure and connected to the source/drain of the second access transistor.

The arrangement of the ground line, the supply voltage line, the bitline, the complementary bitline, and the wordline, supports the reduction of the footprint of the SRAM cell.

A second aspect of this disclosure provides a method for fabricating a static random-access memory, SRAM, device comprising a stack of layer structures comprising three layer structures, the method comprising: forming a first layer structure of the stack, wherein two storage transistors of a storage cell of the SRAM device are formed in the first layer structure; forming a second layer structure of the stack adjacent to the first layer structure, wherein two other storage transistors of the storage cell are formed in the second layer structure; forming a third layer structure of the stack adjacent to the second layer structure, wherein two access transistors are formed in the third layer structure, the two access transistors being configured to control access to the storage cell for storing or reading a bit to or from the storage cell; and wherein each layer structure of the three layer structures comprises a semiconductor material and the transistors in the layer structure are based on the semiconductor material, and wherein at least two of the three layer structures comprise a different type of semiconductor material.

The method of the second aspect achieves the same advantages as the device of the first aspect and may be extended by respective implementations as described above for the device of the first aspect.

In summary, this disclosure proposes a SRAM device, wherein a footprint of one or more SRAM cells is substantially reduced. Several advantages can be achieved by the design of the SRAM cell. For instance, ground line, supply voltage line, bitline(s), and wordline(s) can be organized in a way, which substantially reduces the required wiring. This may also reduce the RC delay. Further, the size of the access transistors can be tuned without changing the footprint of the SRAM cell. For instance, a current in the access transistors can be selected differently than a current in the storage transistors. The different types of semiconductor materials, in particular, the 2D materials and/or semiconductor oxide materials in at least one layer structure combined with a silicon-based material in at least one layer structure, allow reducing the footprint of the SRAM cell without any impact on the classical logic circuitry design. In fact, the other semiconductor materials added to the silicon-based semiconductor materials may bring additional functionality in back-end-of-line (BEOL) processing.

### BRIEF DESCRIPTION OF THE DRAWINGS

The above described aspects and implementations are explained in the following description of embodiments with respect to the enclosed drawings:
- FIG. 1: shows a SRAM cell of a conventional SRAM device.
- FIG. 2: shows a SRAM cell of a SRAM device according to an embodiment of this disclosure in a sectional view.
- FIG. 3: shows a first example of a SRAM cell of a SRAM device according to an embodiment of this disclosure in a sectional view (a) and shows a schema of the SRAM cell (b).
- FIG. 4: shows the first example of the SRAM cell in a top view (a) and shows the schema of the SRAM cell (b).
- FIG. 5: shows a second example of a SRAM cell of a SRAM device according to an embodiment of this disclosure in a sectional view (a) and shows a schema of the SRAM cell (b).
- FIG. 6: shows the second implementation of the SRAM cell in a top view (a) and shows the schema of the SRAM cell (b).
- FIG. 7: shows a flow-diagram of a method for fabricating a SRAM cell of a SRAM device according to an embodiment of this disclosure.
- FIG. 8: shows a first step of an exemplary process of fabricating the first example of the SRAM cell.
- FIG. 9: shows a second step of the process of fabricating the first example of the SRAM cell.
- FIG. 10: shows a third step of the process of fabricating the first example of the SRAM cell.
- FIG. 11: shows a fourth step of the process of fabricating the first example of the SRAM cell.
- FIG. 12: shows a fifth step of the process of fabricating the first example of the SRAM cell.
- FIG. 13: shows a sixth step of the process of fabricating the first example of the SRAM cell.
- FIG. 14: shows a seventh step of the process of fabricating the first example of the SRAM cell.

### DETAILED DESCRIPTION OF EMBODIMENTS OF THE INVENTION

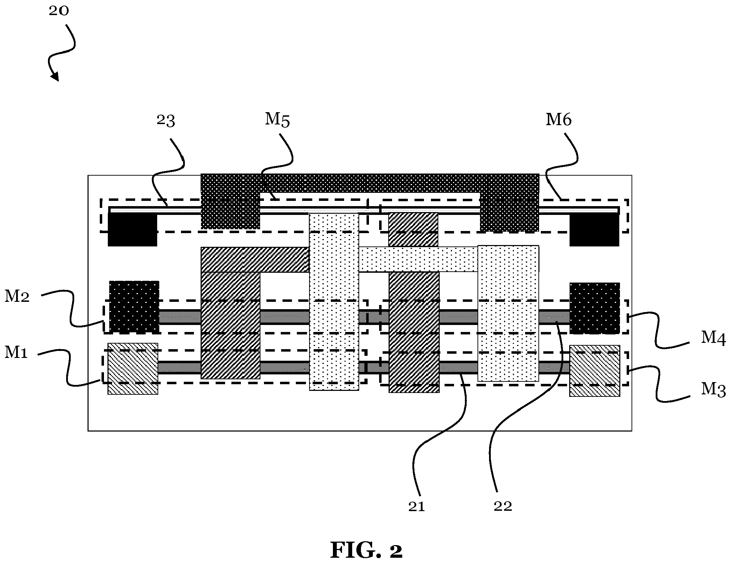

FIG. 2 shows a SRAM cell 20 of a SRAM device according to an embodiment of this disclosure. The SRAM device may have multiple of such SRAM cells 20, and each SRAM cell 20 may be configured to store a bit.

To this end, the SRAM cell 20 comprises a storage cell for storing the bit. The storage cell of the SRAM cell 20 comprises four storage transistors, in particular, it comprises a first storage transistor M1, a second storage transistors M2, a third storage transistor M3, and a fourth storage transistor M4. The four storage transistors M₁-M₄ may form two cross-coupled inverters, as in a conventional SRAM cell (see, e.g., FIG. 1).

Further, the SRAM cell 20 comprises two access transistors, in particular, it comprises a first access transistor M5 and a second access transistor M6. The two access transistors M5 and M6 are configured to control access to the storage cell for storing or reading the bit, as in a conventional SRAM cell (see, e.g., FIG. 1). The SRAM cell 20 also comprises a stack of layer structures, wherein the stack comprises three layer structures, in particular, it comprises a first layer structure 21, a second layer structure 22, and a third layer structure 23. The four storage transistors M1-M4, and the two access transistors M5 and M6, are formed in and distributed over the stack of the three layer structures 21, 22, and 23.

In particular, two storage transistors - for example, the first storage transistor M1 and the third storage transistors M3 - of the four storage transistors M1-M4 are formed in the first layer structure 21 of the stack. The other two storage transistors - in this example, the second storage transistor M2 and the fourth storage transistor M4 - of the four storage transistors M1-M4 are formed in the second layer structure 22 of the stack. The second layer structure 22 is adjacent to the first layer structure 21 in the stack. The two access transistors M5 and M6 are formed in the third layer structure 23 of the stack, wherein the third layer structure 23 is adjacent to the second layer structure 22 of the stack.

Each respective layer structure of the at least three layer structures 21, 22 and 23 comprises a semiconductor material. The respective layer structure of the at least three layer structures 21, 22 and 23 may be formed from that semiconductor material. The transistors, which are arranged in the respective layer structure 21, 22 or 23 are based on said semiconductor material, i.e., are formed using this semiconductor material.

At least two of the three layer structures 21, 22, 23 comprise a different type of semiconductor material. For example, the first layer structure 21 may comprise a first semiconductor material, wherein the first storage transistor M1 and the third storage transistor M3 are based on this first semiconductor material. Further, the second layer structure 22 may comprise a second semiconductor material 22, wherein the second storage transistor M2 and the fourth storage transistor M4 are based on this second semiconductor material. Finally, the third layer structure 23 may comprise a third semiconductor material 22, wherein the first access transistor M5 and the second access transistor M6 are based on this third semiconductor material. For example, the third semiconductor material may be of a different type of semiconductor material than the first semiconductor material and/or than the second semiconductor material.

The first semiconductor material may form the transistor channels of respectively the first storage transistor M1 and the third storage transistor M3. The second semiconductor material may form the transistor channels of respectively the second storage transistor M2 and the fourth storage transistor M4. The third semiconductor material may form the transistor channels of respectively the first access transistor M5 and the second access transistor M6. Possible types of semiconductor materials, which may be used to form the stack, may include silicon-based semiconductor materials, 2D semiconductor materials, and semiconductor oxide materials. An alternative to the silicon-based semiconductor material may be another group IV semiconductor material, for example, germanium. For example, the third semiconductor material is a 2D semiconductor material. In this case the first semiconductor material and/or the second semiconductor material is either a silicon-based semiconductor material and/or a semiconductor oxide material. In another example, the third semiconductor material is a silicon-based semiconductor material. In this case the first semiconductor material and/or the second semiconductor material is either a 2D semiconductor material and/or a semiconductor oxide material. In another example, the third semiconductor material is a semiconductor oxide material. In this case the first semiconductor material and/or the second semiconductor material is either a 2D semiconductor material and/or a silicon-based semiconductor material.

It is possible that each of the three layer structures 21, 22 and 23 is made up of a different type of semiconductor material, i.e., the stack would include at least three different types of semiconductor materials in this case. Generally, however, the stack of layer structures in this disclosure includes at least two different types of semiconductor materials. That is, one layer structure of the stack comprises one type of semiconductor material, while another layer structure of the stack comprises another type of semiconductor material. Notably, each layer structure 21, 22, and 23 of the stack may itself comprise only one type of semiconductor material, or may itself comprise more than one type of semiconductor material. However, two layer structures 21, 22, 23 comprising a different type of semiconductor material preferably do not share a type of semiconductor material.

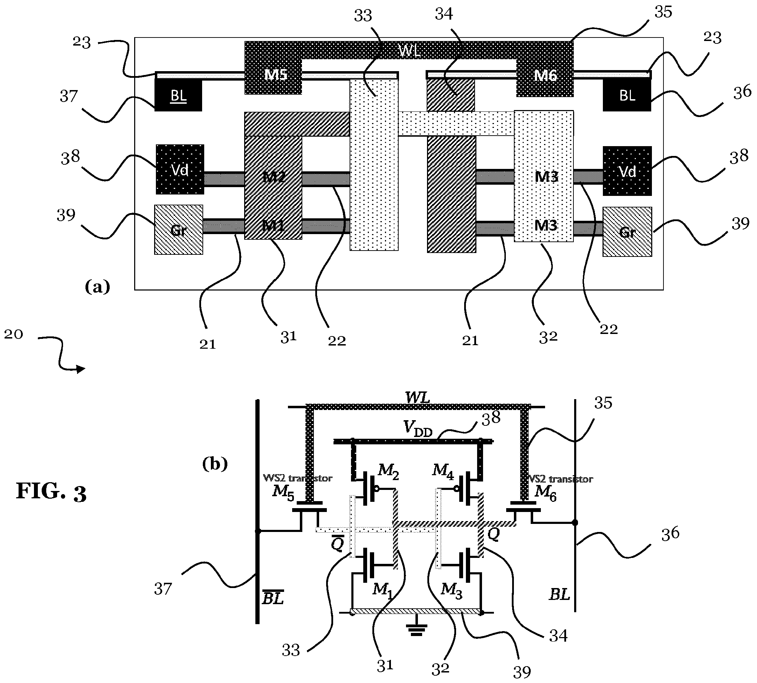

FIG. 3 shows a first example of the SRAM cell 20 of a SRAM device according to an embodiment of this disclosure, which builds on the embodiment shown in FIG. 2. Same elements in FIG. 2 and FIG. 3 are labelled with the same reference signs, and are implemented likewise. In particular, FIG. 3(a) shows the SRAM cell 20 in a sectional view, and FIG. 3(b) shows a schema of the SRAM cell 20.

In the SRAM cell 20 of FIG. 3, the first layer structure 21 and the second layer structure 22 each comprise the same type of semiconductor material, and as a particular example, they both comprise a silicon-based semiconductor material. The third layer structure 23 comprises a different type of semiconductor material than the first and the second layer structure 22 and 23, and in this particular example, it comprises at least one of a 2D semiconductor material and a semiconductor oxide material. The silicon-based semiconductor material may be silicon and/or silicon-germanium. The 2D semiconductor material maybe carbon-based, e.g., graphene, or based on boron nitride or transition metal dichalcogenides. The semiconductor oxide material may be IGZO, ITO, or IZO.

With respect to a direction of stacking the three layer structures 21, 22 and 23 of the stack (along the vertical direction in FIG. 3), the second layer structure 22 is arranged above the first layer structure 21, and the third layer structure 23 is arranged above the first layer structure 21 and the second layer structure 22. The first layer structure 21 maybe arranged on a substrate, or maybe arranged on some base material layer.

In this first example, the SRAM cell 20 may comprise the four storage transistors M1-M4 in the so-called CFET architecture. That is, the first storage transistor M1 and the second storage transistor M2 may constitute a first CFET and the third storage transistor M3 and the fourth storage transistor M4 may constitute a second CFET. At least one of the first CFET and the second CFET may be an integrated silicon-based nanosheet transistor. That is, the SRAM cell 20 maybe based on one or two heterogeneously integrated silicon nanosheet transistors M1/M2 and M₃/M₄, respectively. The integration of the access transistors M5 and M6 based on the 2D semiconductor material and/or the semiconductor oxide material may be on top of the storage transistors M1-M4.

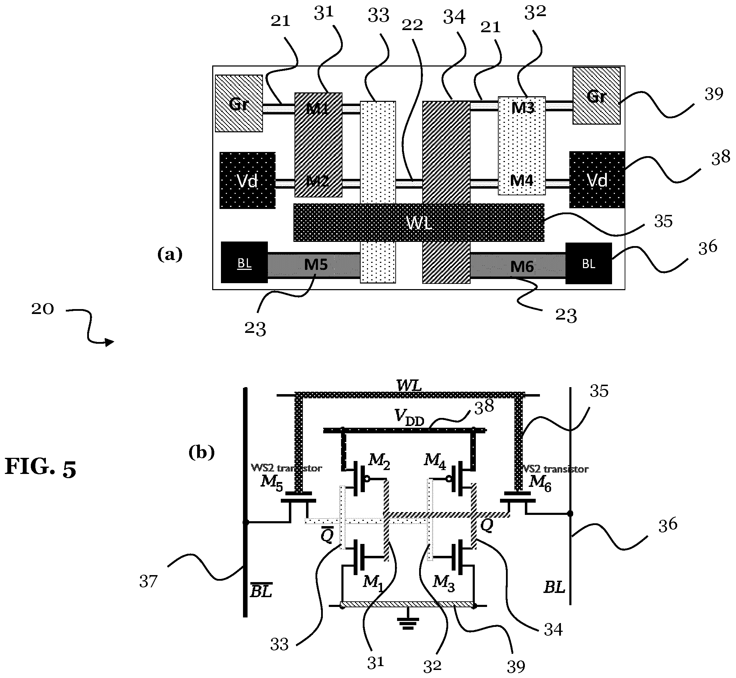

FIG. 5 shows a second example of the SRAM cell 20 of a SRAM device according to an embodiment of this disclosure, which builds on the embodiment shown in FIG. 2. Same elements in FIG. 2 and FIG. 5 are labelled with the same reference signs, and are implemented likewise. In particular, FIG. 5(a) shows the SRAM cell in a sectional view, and FIG. 5(b) shows a schema of the SRAM cell 20.

In the SRAM cell of FIG. 5, the first layer structure 21 and the second layer structure 22 each comprise, as another particular example, a 2D semiconductor material and/or a semiconductor oxide material. That is, they may be formed of the same type or of a different type of semiconductor material (in the latter case, one is based on the 2D semiconductor material, and the other one is based on the semiconductor oxide material). The third layer structure 23 comprises, in any case, a different type of semiconductor material than the first and second layer structures 22, 23, and in this further particular example, it comprises a silicon-based semiconductor material. Again, the silicon-based semiconductor material may be silicon and/or silicon-germanium. The 2D semiconductor material may again be carbon-based, e.g., graphene, or based on boron nitride or transition metal dichalcogenides. The semiconductor oxide material may again be IGZO, ITO, or IZO.

With respect to a direction of stacking the layer structures of the stack (along the vertical direction in FIG. 5), the second layer structure 22 is arranged above the third layer structure 23, and the first layer structure 21 is arranged above the third layer structure 23 and the second layer structure 22. The third layer structure 21 may be arranged on a substrate, or on a base material layer, or the like

In this second example, the SRAM cell 20 may comprise the four storage transistors M1-M4 in the CFET architecture. That is, the first storage transistor M1 and the second storage transistor M2 may constitute a first CFET, and the third storage transistor M3 and the fourth storage transistor M4 may constitute a second CFET.

FIG. 3(b) and FIG. 5(b) show the schema of the respective SRAM cell 20 of FIG. 3(a) and FIG 5(a), which corresponds to the conventional schema shown in FIG. 1. Relevant portions in the schemas of the SRAM cell 20 are labelled and emphasized with different shadings. FIG. 3(a) and FIG. 5(a) show in the sectional view the first and the second example of the SRAM cell 20, respectively, with the corresponding relevant parts labelled and emphasized with the same different shadings. The labelled elements in the sectional view FIG. 3(a) and FIG. 5(a) correspond to the labelled wirings between the different transistors M1-M6 in the SRAM cell 20 as shown in FIG. 3(b) and FIG. 5(b).

It can be seen in both FIG. 3(a) and FIG. 5(a) that the SRAM cell 20 may comprise, in the first example and in the second example, a first vertical element 31, a second vertical element 32, a third vertical element 33, and a fourth vertical element 34. Notably, "vertical" is defined to be along the stacking direction of the stack of the three layer structures 21, 22, and 23 of the SRAM cell 20. "Vertical" may be along the vertical direction (bottom to top) in FIG. 3(a) and FIG. 5(a), which may correspond to a z-axis of a Cartesian coordinate system. The sectional view of the SRAM cell 20 is then along the x-axis of this Cartesian coordinate system, and may be "horizontal" (left to right) in FIG. 3(a) and FIG. 5(a). The y-axis of the Cartesian coordinate system is then into the figure plane in FIG. 3(a) and FIG. 5(a).

The first vertical element 31 is designed to electrically connect a gate of the third storage transistor M3 in the first layer structure 21 to a gate of the fourth storage transistor M4 in the second layer structure 22. The second vertical element 32 is designed to electrically connect a gate of the first storage transistor M1 in the first layer structure 21 to a gate of the second storage transistor M2 in the second layer structure 22. The third vertical element is designed to electrically connect a source/drain of the first storage transistor M1, a source/drain of the second storage transistor M2, and a source/drain of the first access transistor M5. The fourth vertical element 34 is designed to electrically connect a source/drain of the third storage transistor M3, a source/drain of the fourth storage transistor M4, and the source/drain of a second access transistor M6. Each vertical element 31, 32, 33, 34 accordingly connects transistor parts that are formed in different layer structures 21, 22, 23 of the stack, wherein these different layer structures 21, 22, 23 are arranged along the stacking direction of the stack. For example, the layer three structures 21, 22, 23 may be arranged above each along the vertical direction. In this sense, each vertical element is at least partly vertical, but does not have to be only vertical (in its extension). Further, the first vertical element 31 is designed to be electrically connected to the fourth vertical element 34, and the second vertical element 32 is designed to be electrically connected to the third vertical element 33 in the first example or the second example of the SRAM cell 20. The electrical connections provided by the vertical elements 31-34 correspond to the wirings between the transistors M1-M6, which are shown in the schema of FIG. 3(b) and FIG. 5(b) respectively.

In addition, it can be seen in FIG. 3(a) and FIG. 5(a) that the SRAM cell 20, in the first and in the second example, has a source/drain of the first storage transistor M1 and a source/drain of the third storage transistor M3 connected to a ground line 39. Further, a source/drain of the second storage transistor M2 and a source/drain of the fourth storage transistor M4 are connected to a supply voltage line 38 (also "Vd" or "Vdd" in this disclosure).

Finally, it can be seen in FIG. 3(a) and FIG. 5(a) that the SRAM cell 20, in the first and in the second example, comprises a wordline 35, a bitline 36, and a complementary bitline 37. The wordline 35 in the first example is arranged above the stack, and is electrically connected to the gates of the two access transistors M5 and M6. The wordline 35 in the second example is arranged between the second layer structure 22 and the third layer structure 23, and is electrically connected to the gates of the two access transistors M5 and M6. The bitline 36 is arranged in the third layer structure 23 in both examples, and is connected to the source/drain of the first access transistor M5. The complementary bitline 37 is arranged in the third layer structure 23 in both example, and is connected to the source/drain of the second access transistor M6.

The ground line 39, supply voltage line 38, bitline 36, complementary bitline 37, and wordline 39 are also shown in the schema of the SRAM cell 20 in FIG. 3(b) and FIG. 5(b).

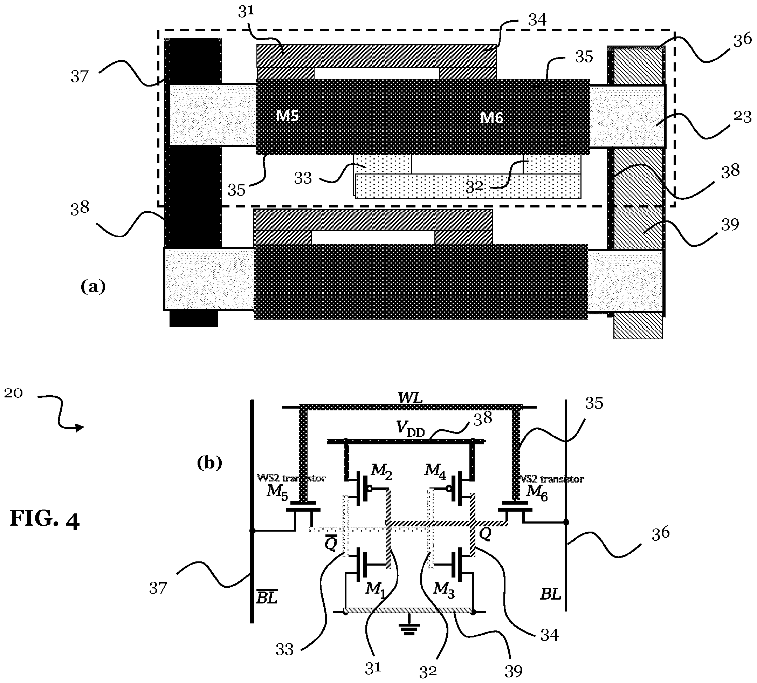

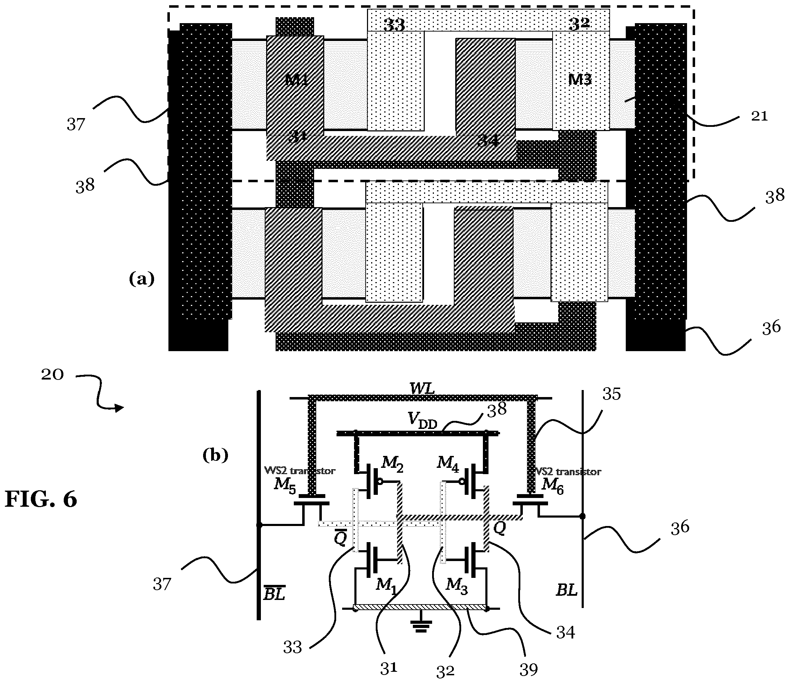

FIG. 4(a) shows the first example of the SRAM cell 20 in a top view, and FIG. 4(b) shows the same schema as in FIG. 3(b) for ease of reference. FIG. 6 shows the second example of the SRAM cell 20 in a top view, and FIG. 6(b) shows the same schema as in FIG. 5(b) for ease of reference. Same elements in FIG. 4 and FIG 3, as well as FIG. 6 and FIG. 5 are labelled likewise and shown in the same shadings. The top views of the SRAM cell 20 in FIG. 4(b) and FIG. 6(b) show the SRAM cell 20 along the above-mentioned x-axis (left to right) and y-axis (bottom to top) of the Cartesian coordinate system, while the z-axis is into the figure plane.

The dashed square in FIG. 4(a) and FIG 6(a), respectively, indicates the final footprint of one SRAM cell 20. Notably, in these figures, two SRAM cells 20 are shown next to each other, which share the same bitline 36, wordline 35, ground line 39 and supply voltage line 38. As can be seen, the small footprint of the SRAM cell 20 is achieved by the stacking of the three layer structures, comprising two transistors each, and the (vertical) connection elements used for connecting the six transistors as shown in the schema of the SRAM cell 20.

The two flip-flops (cross-coupled inverters, which are formed by the storage transistors M1-M4) are integrated in the first layer structure 21 and the second layer structure 22, respectively, while the access transistors that may drive (read and write) the flip-flops are integrated in the third layer structure 23. In the first example of the SRAM cell 20, the access transistors M5 and M6 may be freely accessible for the wordline and the bitline(s).

The design of the SRAM cell 20 allows greatly simplifying the interconnect scheme, as there is no need to connect the ground line 39 and the supply voltage line 38 connection to the top of the SRAM cell 20 (third layer structure 23 in the first example, first layer structure 21 in the second example). Instead they can be connected at the beginning and the end of the SRAM arrays comprising multiple SRAM cells 20. Notably, in the integration scheme, the contact to the transistors M1 and M3 and the gates of the transistors M2 and M4 may be slightly shifted to make the connection better possible. Finally, since in the first example of the SRAM cell 20 the access transistors M5 and M6 are on top of the SRAM cell 20, a channel width of these access transistors M5 and M6 can be fine-tuned to optimize the read and write current of the SRAM cell 20, and to fine-tune the switching speed.

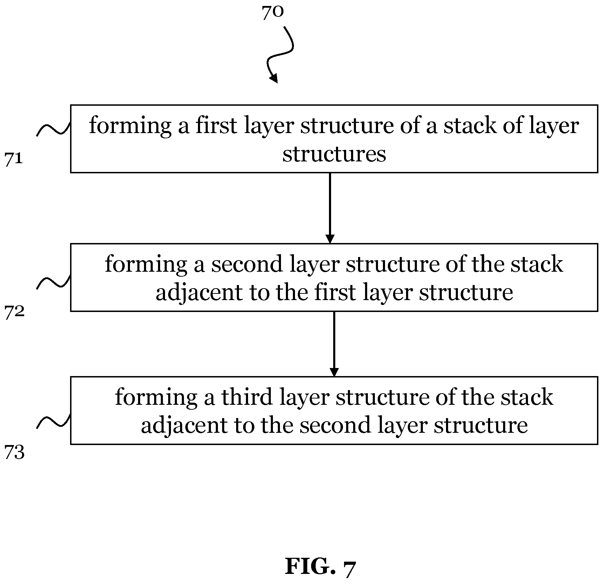

FIG. 7 shows a flow-diagram of a basic method 70, which may be used to fabricate the SRAM cell 20 according to an embodiment of this disclosure, in particular, the one shown in FIG. 2. The method 70 may thus also be used to fabricate the SRAM device comprising the stack of layer structures comprising the three layer structures 21, and 22 and 23.

The method 70 comprises a step 71 of forming the first layer structure 21 of the stack, wherein two storage transistors, e.g. M1 and M3, of the storage cell of the SRAM device are formed in the first layer structure 21. Further, the method 70 comprises a step 72 of forming the second layer structure 22 of the stack adjacent to the first layer structure 21, wherein two other storage transistors, e.g. M2 and M4, of the storage cell are formed in the second layer structure 22. The method 70 also comprises a step 73 of forming the third layer structure of the stack adjacent to the second layer structure 22, wherein the two access transistors M5 and M6 are formed in the third layer structure 23. The method 70 is performed such that each layer structure of the three layer structures 21, 22, and 23 comprises a semiconductor material, wherein the transistors in the layer structure are based on the semiconductor material, and such that at least two of the three layer structures 21, 22, and 23 comprise a different type of semiconductor material. Notably, there is no particular order in which the steps 71-73 are to be performed, and neither step has to be completed before another step may be started.

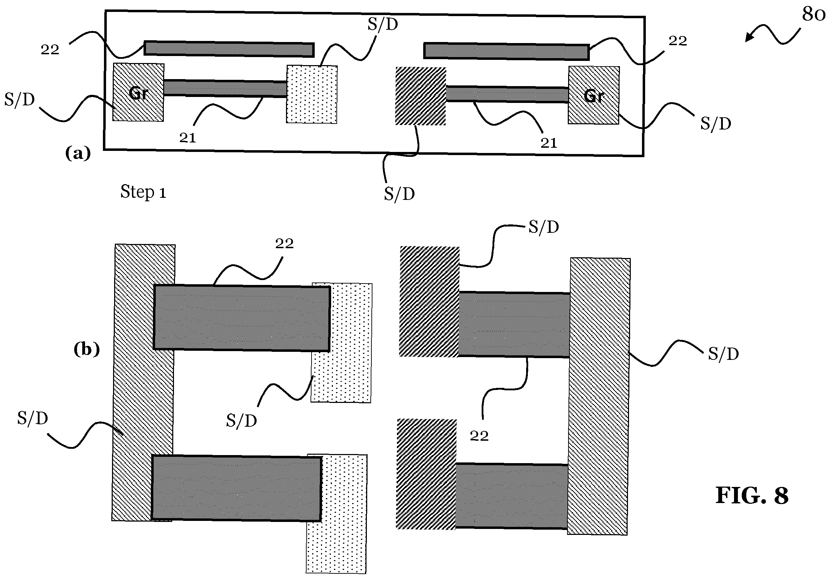

FIG. 8-14 show a specific process 80 for fabricating the first example of the 3-level stacked SRAM cell 20 shown in FIG. 3 and FIG. 4. The figures show over time the sectional view (showing the x-axis and z-axis) in (a) and the top view (showing the x-axis and y-axis, and being indicative of the footprint) of the proposed integrated SRAM cell 20 in (b).

FIG. 8 shows a first step of the process 80, in which the first layer structure 21 and the second layer structure 22 are formed on top of each other. For instance, the first layer structure 21 and the second layer structure 22 may be doped to the N-type and the P-Type, respectively, and maybe processed like a conventional CFET (e.g. using the Intel Flow). In particular, the first layer structure 21 and the second layer structure 22 may each be a silicon nanosheet. Source/Drain (S/D) contacts may be processed in the first layer structure 21 (which may, e.g., be an N-type silicon nanosheet), wherein these S/D contacts are for the first storage transistor M1 and the third storage transistor, respectively, which are formed in the first layer structure 21. The outer S/D contacts in FIG. 8 may be intended for ground (Gr), which maybe connected to the S/D of the first storage transistor M1 and to the S/D of the third storage transistor M3 in the final SRAM cell 20.

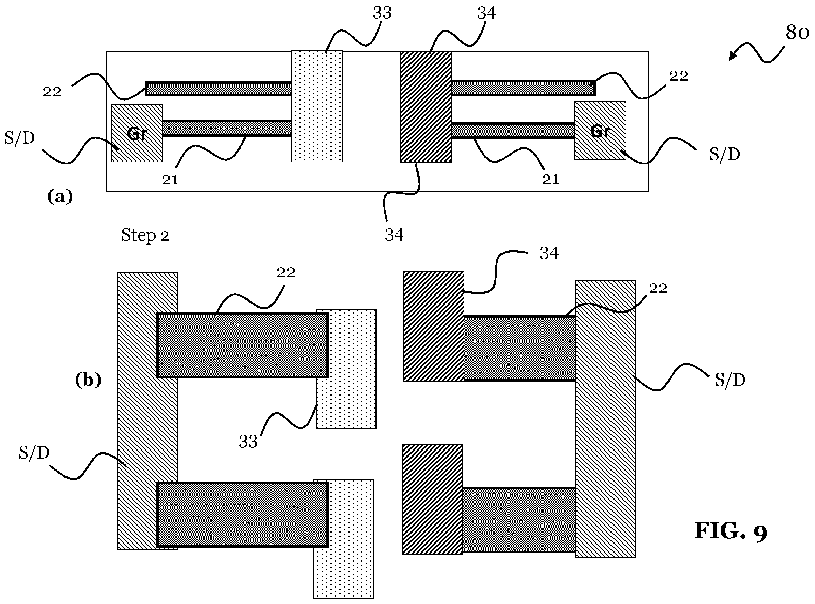

FIG. 9 shows a second step of the process 80, in which S/D contacts are also made in the second layer structure 22 (which may, e.g., be a P-type silicon nanosheet), wherein these S/D contacts made in the second layer structure 22 are connected to the S/D contacts made in the first layer structure 21, in the middle of SRAM cell 20. The S/D contacts made in the second layer structure 22 are for the second storage transistor M2 and the fourth storage transistor M4, respectively, which are formed in the second layer structure 22. The connection may be realized by forming the third vertical element 33 and the fourth vertical element 34. The third vertical element 33 at this stage of the process 80 connects the S/D for the first storage transistor M1 with the S/D for the second storage transistor M2. The fourth vertical element 34 at this stage of the process 80 connects the S/D for the third storage transistor M3 and the S/D for the fourth storage transistor M4.

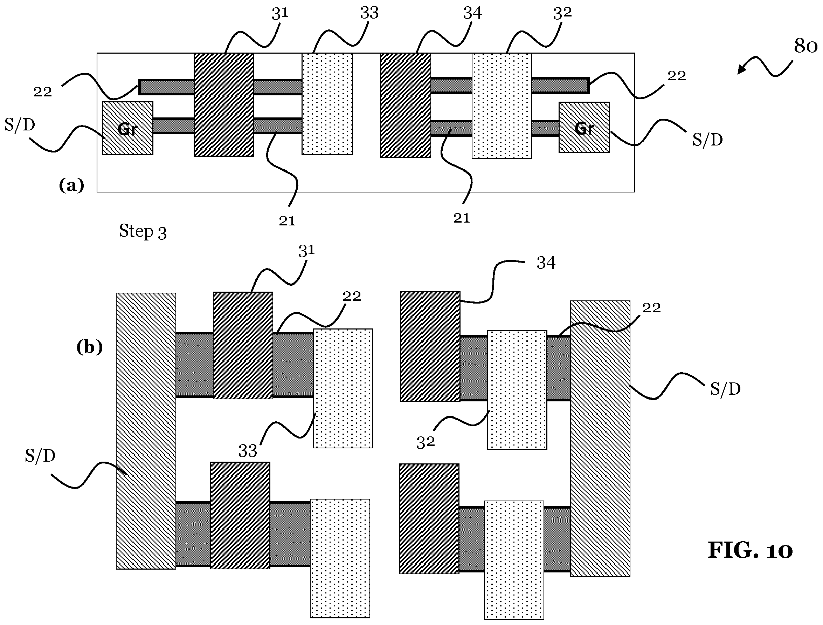

FIG. 10 shows a third step of the process 80, in which gate contacts are processed in the first layer structure 21 and the second layer structure 22, in particular, for the storage transistors M1-M4. The gate contacts are processed by forming the first vertical element 31 and the second vertical element 32. At this stage of the process 80, the first vertical element 31 connects a gate for the first storage transistor M1 in the first layer structure 21 to a gate for the second storage transistor M2 in the second layer structure 22, and the second vertical element 32 connects a gate for the third storage transistor M3 in the first layer structure 21 to a gate of the fourth storage transistor M4 in the second layer structure 22.

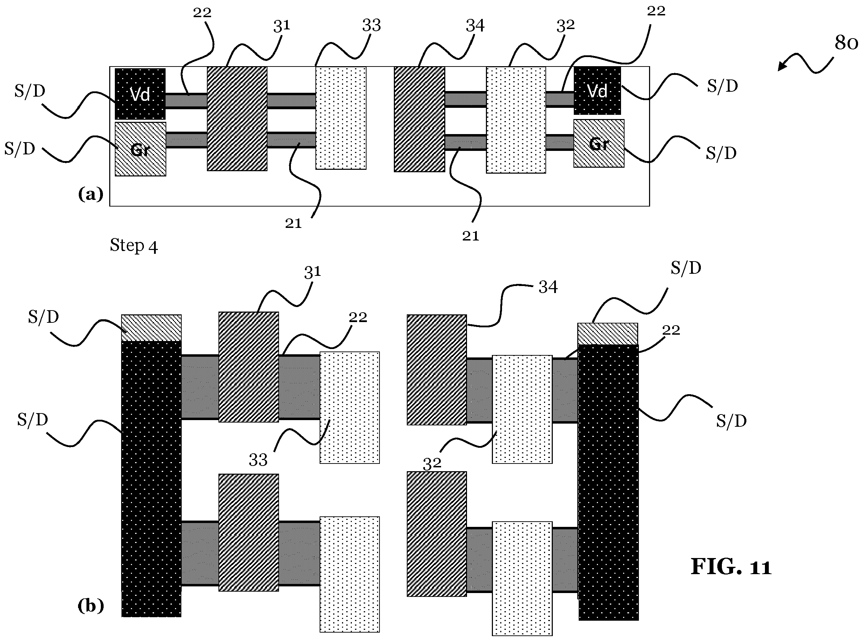

FIG. 11 shows a fourth step of the process 80, in which a further S/D contact is formed in the second layer structure. This S/D contact is intended for the supply voltage (Vd), which maybe supplied to the S/D of the second storage transistor M2 and to the S/D of the fourth storage transistor M4 in the final SRAM cell 20.

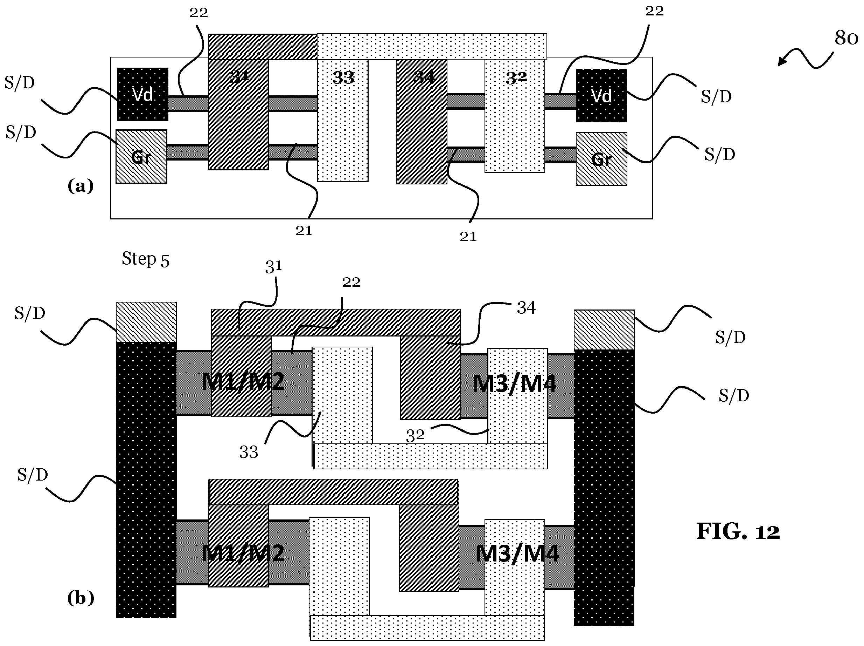

FIG. 12 shows a fifth step of the process 80, in which the storage transistors Mi-M4 are connected. In particular, the gates of the first and the second storage transistor M1 and M2, which are connected to each other by the first vertical element 31, are further connected to the S/D contact of the third and the fourth storage transistor M3 and M4, which are already connected to each other by the fourth vertical element. The further connection is realized by connecting the first vertical element 31 to the fourth vertical element 34. Further, the S/D contacts of the first and the second storage transistor M1 and M2, which are connected to each other by the third vertical element 33, are further connected to the gates of the third and the fourth storage transistor M3 and M4, which are already connected to each other by the second vertical element. This further connection is realized by connecting the third vertical element 33 to the second vertical element 32.

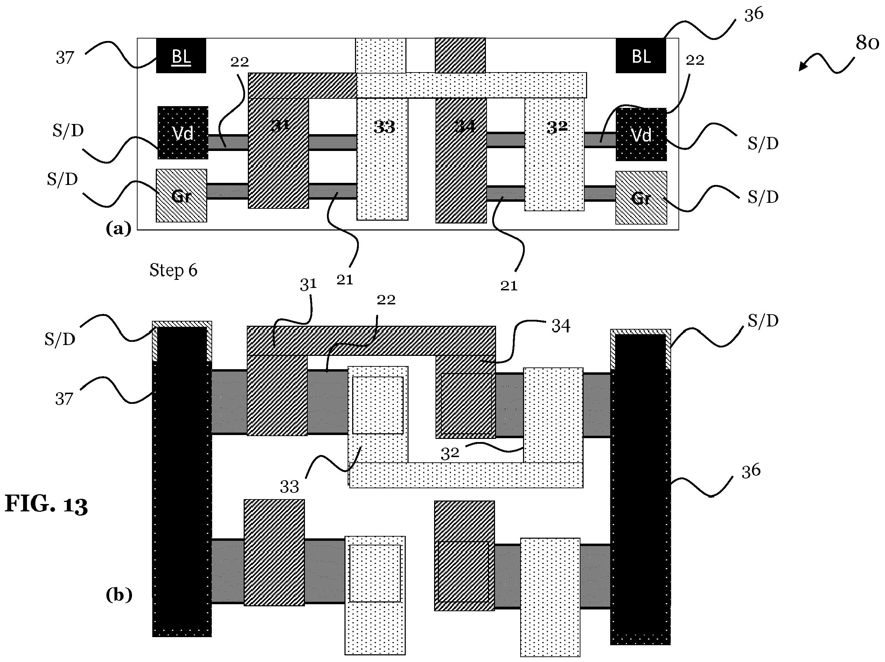

FIG. 13 shows a sixth step of the process 80, in which the bitline 36 and the complementary bitline 37 are formed, and in which further contacts to the storage transistors Mi-M$ are processed by vertically extending the third vertical element 33 and the fourth vertical element 34 (as also indicated by the squares in FIG, 13(b)).

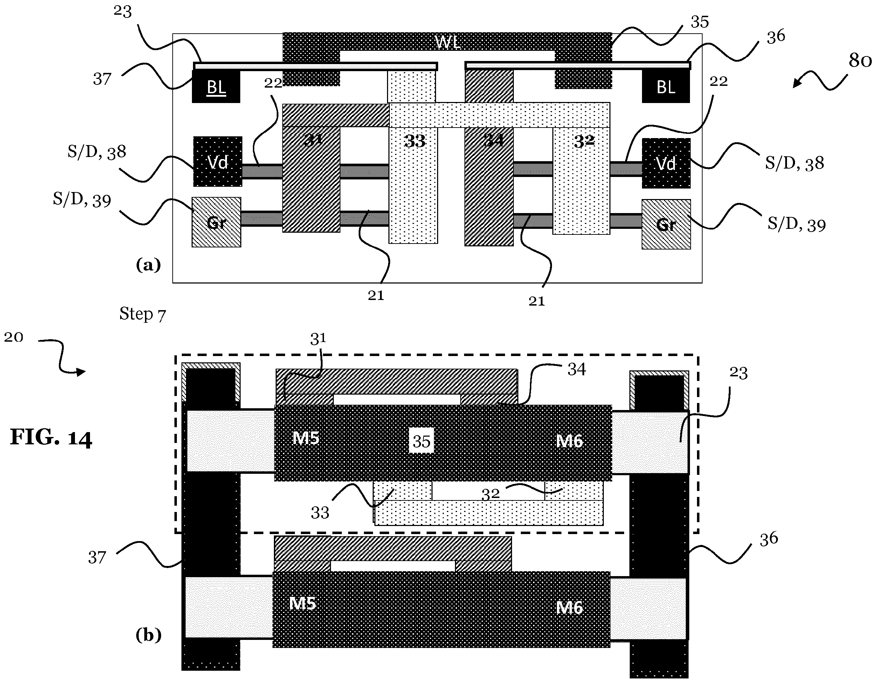

FIG. 14 shows a seventh step of the process 80, in which the third layer structure 23 is processed, and the wordline 35 is processed. Processing the third layer structure 23 includes forming the first and second access transistors M5 and M6. The bitline 36 is connected to the S/D of the first access transistor M5, and the complementary bitline 37 is connected to the S/D of the second access transistor M6. The wordline 35 is connected to the gates of the two access transistors M5 and M6. This step concludes the processing of the SRAM cell 20.

Two or more SRAM cells 20 maybe processed in parallel according to this process 80. FIG. 14(b) shows again that this process 80 finally achieves a SRAM cell 20 with a very small footprint. Nevertheless, the SRAM cell 20 can still be wired according to the conventional SRAM schema shown e.g. in FIG. 1.

## Claims

1. A static random-access memory, SRAM, device comprising:
a storage cell for storing a bit, the storage cell comprising four storage transistors (M1, M2, M3, M4);
two access transistors (M5, M6) configured to control access to the storage cell for storing or reading the bit; and
a stack of layer structures comprising three layer structures (21, 22, 23);
wherein two storage transistors (M1, M3) of the four storage transistors are formed in a first layer structure (21) of the stack;
wherein two other storage transistors (M2, M4) of the four storage transistors are formed in a second layer structure (22) of the stack adjacent to the first layer structure (21);
wherein the two access transistors (M5, M6) are formed in a third layer structure (23) of the stack adjacent to the second layer structure (22);
wherein each layer structure of the three layer structures (21, 22, 23) comprises a semiconductor material and the transistors (M1-M6) in the layer structure are based on the semiconductor material; and
wherein at least two of the three layer structures (21, 22, 23) comprise a different type of semiconductor material.

2. The SRAM device according to claim 1, wherein the type of semiconductor material comprises: a silicon-based semiconductor material, or a two-dimensional, 2D, semiconductor material, or a semiconductor oxide material.

3. The SRAM device according to claim 1 or 2, wherein:
the first layer structure (21) and the second layer structure (22) each comprises a silicon-based semiconductor material; and
the third layer structure (23) comprises a 2D semiconductor material and/or a semiconductor oxide material.

4. The SRAM device according to claim 3, wherein with respect to a direction of stacking the layer structures (21, 22, 23) of the stack:
the second layer structure (22) is formed above the first layer structure (21), and the third layer structure (23) is formed above the first layer structure (21) and the second layer structure (22).

5. The SRAM device according to claim 1 or 2, wherein:
the first layer structure (21) and the second layer structure (22) each comprises a 2D semiconductor material and/or a semiconductor oxide material; and
the third layer structure (23) comprises a silicon-based semiconductor material.

6. The SRAM device according to claim 5, wherein with respect to a direction of stacking the layer structures (21, 22, 23) of the stack:
the second layer structure (22) is formed above the third layer structure (23), and the first layer structure (21) is formed above the third layer structure (23) and the second layer structure (22).

7. The SRAM device according to one of the claims 1 to 6, wherein the first layer structure (21) is a doped layer structure of a first-conductivity type, and the second layer structure (22) is a doped layer structure of a second conductivity-type.

8. The SRAM device according to one of the claims 1 to 7, wherein:
the first storage transistor (M1) and the second storage transistor (M2) constitute a first complementary field effect transistor, CFET; and/or
the third storage transistor (M3) and the fourth storage transistor (M4) constitute a second CFET.

9. The SRAM device according to claim 8 and claim 3, wherein:
the first CFET and/or the second CFET is an integrated silicon-based nanosheet transistor.

10. The SRAM device according to one of the claims 1 to 9, further comprising:
a first vertical element (31) electrically connecting a gate of a first storage transistor (M1) of the two storage transistors in the first layer structure (21) to a gate of a second storage transistor (M2) of the two other storage transistors in the second layer structure (22); and/or
a second vertical element (32) electrically connecting a gate of a third storage transistor (M3) of the two storage transistors in the first layer structure (21) to a gate of a fourth storage transistor (M4) of the two other storage transistors in the second layer structure (22).

11. The SRAM device according to claim 10, further comprising:
a third vertical element (33) electrically connecting a source/drain of the first storage transistor (M1), a source/drain of the second storage transistor (M2), and a source/drain of a first access transistor (M5) of the two access transistors; and/or
a fourth vertical element (34) electrically connecting a source/drain of the third storage transistor (M3), a source/drain of the fourth storage transistor (M4), and a source/drain of a second access transistor (M6) of the two access transistors.

12. The SRAM device according to claim 10 and 11, wherein:
the first vertical element (31) is electrically connected to the fourth vertical element (34); and/or
the second vertical element (32) is electrically connected to the third vertical element (33).

13. The SRAM device according to one of the claims 10 to 12, wherein:
a source/drain of the first storage transistor (M1) and a source/drain of the third storage transistor (M3) are connected to a ground line (39); and
a source/drain of the second storage transistor (M2) and a source/drain of the fourth storage transistor (M4) are connected to a supply voltage line (38).

14. The SRAM device according to one of the claims 1 to 13, further comprising:
a wordline (35) arranged above the stack and electrically connected to the gates of the two access transistors (M5, M6); or
a wordline (35) arranged between the second layer structure (22) and the third layer structure (23) and electrically connected to the gates of the two access transistors (M5, M6); and
the SRAM device further comprising:
a bitline (36) arranged in the third layer structure (23) and connected to the source/drain of the first access transistor (M5), and a complementary bitline (37) arranged in the third layer structure (23) and connected to the source/drain of the second access transistor (M6).

15. A method (70, 80) for fabricating a static random-access memory, SRAM, device comprising a stack of layer structures comprising three layer structures (21, 22, 23), the method (70, 80) comprising:
forming (71) a first layer structure (21) of the stack, wherein two storage transistors (M1, M3) of a storage cell of the SRAM device are formed in the first layer structure (21);
forming (72) a second layer structure (22) of the stack adjacent to the first layer structure (21), wherein two other storage transistors (M2, M4) of the storage cell are formed in the second layer structure (22);
forming (73) a third layer structure of the stack adjacent to the second layer structure (22), wherein two access transistors (M5, M6) are formed in the third layer structure (23), the two access transistors (M5, M6) being configured to control access to the storage cell for storing or reading a bit to or from the storage cell; and
wherein each layer structure of the three layer structures (21, 22, 23) comprises a semiconductor material and the transistors in the layer structure are based on the semiconductor material, and wherein at least two of the three layer structures (21, 22, 23) comprise a different type of semiconductor material.
